# EUROPEAN PATENT APPLICATION

(11) **EP 4 628 912 A1**
(43) Date of publication of application: **08.10.2025**
(21) Application number: 23907494.1
(22) Date of filing: 01.12.2023
(51) Int. Cl.: G01R 31/396, G01R 31/367, G01R 31/52, G01R 31/36, G08B 21/18

(54) **BATTERY DIAGNOSTIC DEVICE AND OPERATION METHOD THEREOF**

(30) Priority: 23.12.2022 KR 20220183673
(71) Applicant: LG Energy Solution, Ltd., Seoul 07335 (KR)
(72) Inventor: SHIN, Hyeon Ju, Daejeon 34122 (KR)
(74) Representative: Plasseraud IP
(86) International application number: PCT/KR2023/019634
(87) International publication number: WO 2024/136208

(57) **Abstract**

A battery diagnosis apparatus according to an embodiment disclosed herein includes an obtaining unit configured to obtain a balancing execution time of a battery unit, a calculating unit configured to calculate at least one balancing execution rate based on the balancing execution time, and a diagnosing unit configured to diagnose abnormality of the battery unit by comparing a designated balancing execution rate corresponding to a designated period with a reference rate.

## Description

### [TECHNICAL FIELD]

### CROSS-REFERENCE TO RELATED APPLICATION

This application claims priority to and the benefit of Korean Patent Application No. 10-2022-0183673 filed in the Korean Intellectual Property Office on December 23, 2022, the entire content of which is incorporated herein by reference.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

Meanwhile, a plurality of battery units (e.g., battery cells, battery modules, battery packs, or battery racks) connected to each other in series or in parallel may have an imbalance in their charging states over time due to differences in capacity. As a result, problems such as reducing a capacity of all battery units and thus shortening the lifetime thereof, etc., due to overcharging or overdischarging of a specific battery unit may occur.

To solve such problems, it is important to uniformly balance states of charge (SOC) of the battery units. For example, when an SOC deviation between battery units is at a specific level or higher, balancing may be performed using balancing current.

### [DISCLOSURE]

### [TECHNICAL PROBLEM]

However, a balancing function may artificially reduce an SOC deviation between battery units, preventing abnormality of a battery unit from being diagnosed quickly. Due to the balancing function, even an abnormal battery unit having internal shortcircuit or other types of failures may not be early diagnosed in terms of abnormality.

Embodiments disclosed herein provide a battery diagnosis apparatus and an operating method thereof in which abnormality of a battery unit may be diagnosed by using a feature that an abnormal battery unit has a higher balancing execution rate due to an SOC deviation from the other normal battery units.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to an embodiment disclosed herein includes an obtaining unit configured to obtain a balancing execution time of a battery unit, a calculating unit configured to calculate at least one balancing execution rate based on the balancing execution time, and a diagnosing unit configured to diagnose abnormality of the battery unit by comparing a designated balancing execution rate corresponding to a designated period with a reference rate.

In the battery diagnosis apparatus according to an embodiment disclosed herein, the calculating unit may be further configured to calculate the designated balancing execution rate based on a value obtained by dividing the balancing execution time of the battery unit during the designated period by the designated period.

The battery diagnosis apparatus according to an embodiment disclosed herein may further include a determining unit configured to determine the reference rate based on another balancing execution rate corresponding to another period before the designated period.

The battery diagnosis apparatus according to an embodiment disclosed herein may further include a determining unit configured to determine the reference rate based on another balancing execution rate of another battery unit of the same model as the battery unit.

In the battery diagnosis apparatus according to an embodiment disclosed herein, the diagnosing unit may be further configured to diagnose the battery unit as an abnormal battery unit when a difference between the designated balancing execution rate and the reference rate is greater than or equal to a designated value.

The battery diagnosis apparatus according to an embodiment disclosed herein may further include an abnormality processing unit configured to perform an abnormality processing function based on an abnormality diagnosis result of the battery unit, in which the abnormality processing function includes a notification function and/or a shortcircuit function.

In the battery diagnosis apparatus according to an embodiment disclosed herein, the abnormality processing unit may be further configured to perform the notification function with respect to the abnormality diagnosis result and/or information related to the battery unit, and the information related to the battery unit may include manufacturing information of the battery unit and/or position information regarding arrangement of the battery unit.

In the battery diagnosis apparatus according to an embodiment disclosed herein, the battery unit may be a battery cell, a battery module, a battery pack, or a battery rack.

A battery diagnosis method according to an embodiment disclosed herein includes obtaining a balancing execution time of a battery unit, calculating at least one balancing execution rate based on the balancing execution time, and diagnosing abnormality of the battery unit by comparing a designated balancing execution rate corresponding to a designated period with a reference rate.

In the battery diagnosis method according to an embodiment disclosed herein, the calculating of the at least one balancing execution rate may include calculating the designated balancing execution rate based on a value obtained by dividing the balancing execution time of the battery unit during the designated period by the designated period.

The battery diagnosis method according to an embodiment disclosed herein may further include determining the reference rate based on another balancing execution rate corresponding to another period before the designated period.

The battery diagnosis method according to an embodiment disclosed herein may further include determining the reference rate based on another balancing execution rate of another battery unit of the same model as the battery unit.

In the battery diagnosis method according to an embodiment disclosed herein, the diagnosing of abnormality of the battery unit may include diagnosing the battery unit as an abnormal battery unit when a difference between the designated balancing execution rate and the reference rate is greater than or equal to a designated value.

The battery diagnosis method according to an embodiment disclosed herein may further include performing an abnormality processing function based on an abnormality diagnosis result of the battery unit, in which the abnormality processing function includes a notification function or a shortcircuit function.

In the battery diagnosis method according to an embodiment disclosed herein, the performing of the abnormality processing function may include performing the notification function with respect to the abnormality diagnosis result and/or information related to the battery unit, and the information related to the battery unit may include manufacturing information of the battery unit and/or position information regarding arrangement of the battery unit.

### [ADVANTAGEOUS EFFECTS]

A battery diagnosis apparatus and an operating method thereof according to various embodiments disclosed herein may detect occurrence of a short circuit or a failure of another type inside a battery.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

Moreover, various effects recognized directly or indirectly from the disclosure may be provided.

### [DESCRIPTION OF DRAWINGS]

FIG. 1 is a block diagram of a battery diagnosis apparatus according to an embodiment.
FIG. 2 is a view for describing an example where a balancing execution rate of an abnormal battery unit according to an embodiment increases with a period change.
FIG. 3 is a view for describing an example where balancing execution rates of abnormal battery units according to an embodiment increases with a period change.
FIG. 4 is an operating flowchart of a battery diagnosis apparatus according to an embodiment.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

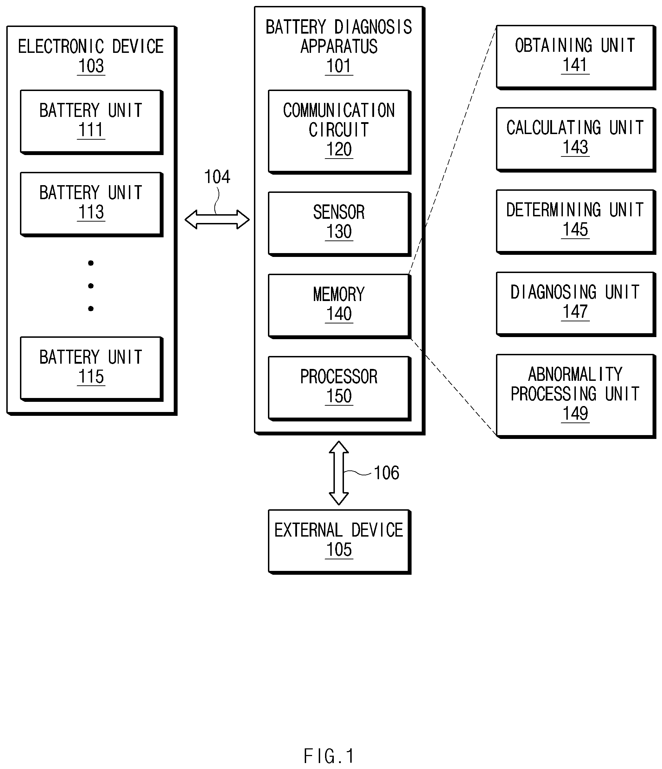

FIG. 1 is a block diagram of a battery diagnosis apparatus according to an embodiment.

Referring to FIG. 1, a battery diagnosis apparatus 101 may be wiredly and/or wirelessly connected to an electronic device 103 and/or an external device 105.

According to an embodiment, connection 104 between the battery diagnosis apparatus 101 and the electronic device 103 may be communication connection through a wired and/or wireless network. According to an embodiment, the wired network may be based on a local area network (LAN) communication or a power-line communication. According to an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection 104 between the battery diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

According to an embodiment, connection 106 between the battery diagnosis apparatus 101 and the external device 105 may be communication connection through a wired and/or wireless network.

According to an embodiment, the electronic device 103 may be a mobile device (e.g., a mobile phone, a laptop computer, a smart phone, a smart pad), en electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to an embodiment, the electronic device 103 may include one or more battery units 111, 113, and 115. Each of the one or more battery units 111, 113, and 115 may be a battery cell, a battery module, a battery pack, or a battery rack.

According to an embodiment, the external device 105 may be a user terminal or an external server. Herein, the user terminal may be a mobile device (e.g., a mobile phone, a laptop computer, a smart phone, a smart pad), or a personal computer (PC).

According to an embodiment, the battery diagnosis apparatus 101 may include a communication circuit 120, a sensor 130, a memory 140, and a processor 150. According to an embodiment, the battery diagnosis apparatus 101 shown in FIG. 1 may further include at least one component (e.g., a display, an input device, or an output device) in addition to components shown in FIG. 1.

According to an embodiment, the communication circuit 120 may establish a wired communication channel and/or a wireless communication channel between the battery diagnosis apparatus 101 and the electronic device 103 and/or the external device 105, and transmit and receive data to and from the electronic device 103 and/or the external device 105 through the established communication channel.

According to an embodiment, the sensor 130 may obtain values related to states of the battery units 111, 113, and 115 of the electronic device 103. According to an embodiment, the values related to the states may indicate one or more values of voltages, currents, resistances, states of charge (SoC), states of health (SoH), or temperatures of the battery units 111, 113, and 115 or combinations thereof. Hereinbelow, the value related to the state may be referred to as a 'state value'.

According to an embodiment, the memory 140 may include a volatile and/or a nonvolatile memory.

According to an embodiment, the memory 140 may store data used by at least one component (e.g., the processor 150) of the battery diagnosis apparatus 101. For example, the data may include software (or an instruction related thereto), input data, or output data. According to an embodiment, the instruction, when executed by the processor 150, may cause the battery abnormality diagnosis apparatus 101 to perform operations defined by the instruction.

According to an embodiment, the memory 140 may include one or more software (e.g., an obtaining unit 141, a calculating unit 143, a determining unit 145, a diagnosing unit 147, and an abnormality processing unit 149).

According to an embodiment, the processor 150 may include a central processing unit, an application processor, a graphic processing unit, a neural processing unit (NPU), an image signal processor, a sensor hub processor, or a communication processor.

According to an embodiment, the processor 150 may execute software (e.g., the obtaining unit 141, the calculating unit 143, the determining unit 145, the diagnosing unit 147, and the abnormality processing unit 149) to control at least one other component (e.g., a hardware or software component) of the battery diagnosis apparatus 101 connected to the processor 150 and perform various data processing or operations.

Hereinbelow, a description will be made of a method, performed by the battery diagnosis apparatus 101, of diagnosing abnormality of the battery unit 111, 113, or 115 through the obtaining unit 141, the calculating unit 143, the diagnosing unit 147, and/or the abnormality processing unit 149.

According to an embodiment, the obtaining unit 141 may obtain a balancing execution time of the battery unit 111, 113, or 115. According to an embodiment, the obtaining unit 141 may obtain the balancing execution time of the battery unit 111, 113, or 115 from the electronic device 103 connected through a wired and/or wireless network. Herein, the balancing execution time may mean a time at which balancing is uniformly executed on states of charge (SoC) having a deviation among the battery units 111, 113, and 115. Such balancing may be performed autonomously inside the electronic device 103. The balancing execution time may mean a time at which the battery unit 111, 113, or 115 executes balancing from a first point in time to a second point in time.

According to an embodiment, the obtaining unit 141 may obtain a balancing execution time and/or a balancing execution rate of another battery unit of the same model as the battery unit 111, 113, or 115. According to an embodiment, the obtaining unit 141 may obtain the balancing execution time and/or balancing execution rate of the other battery unit from the external device 105 (e.g., an external server) connected through a wired and/or wireless network. Herein, the other battery unit may be of the same model as the battery unit 111, 113, or 115 and may mean a battery unit arranged in an electronic device other than the electronic device 103.

According to an embodiment, the calculating unit 143 may calculate at least one balancing execution rate based on the balancing execution time of the battery unit 111, 113, or 115 obtained through the obtaining unit 141. For example, the calculating unit 143 may calculate the balancing execution rate for each of a plurality of periods included in a period from the first point in time to the second point in time of the battery unit 111, 113, or 115.

According to an embodiment, the calculating unit 143 may calculate a designated balancing execution rate based on a balancing execution time of a designated period in the obtained balancing execution time, and the designated period. In an embodiment, the calculating unit 143 may calculate the designated balancing execution rate based on a value obtained by dividing the balancing execution time of the designated period by the designated period.

According to an embodiment, the calculating unit 143 may calculate another balancing execution rate based on another balancing execution time of another period before the designated period in the obtained balancing execution time, and the other period. In an embodiment, the calculating unit 143 may calculate the other balancing execution rate based on a value obtained by dividing the other balancing execution time of the other period by the other period. Herein, the other period may have a duration that is the same as or different from the designated period.

Hereinbelow, for convenience of a description, the description will be made assuming that the obtaining unit 141 obtains the balancing execution time of the battery unit 111, 113, or 115 from the first point in time to the second point in time. The other period from a third point in time after the first point in time to a fourth point in time before the second point in time may be referred to as a first period, and the designated period from the fourth point in time to the second point in time may be referred to as a second period. The balancing execution time of the first period (or the second period) may be referred to as a first balancing execution time (or a second balancing execution time), and the other balancing execution rate (or the designated balancing execution rate) may be referred to as a first balancing execution rate (or a second balancing execution rate). However, this is merely an example, and the designated period and the other period may be set variously.

For example, the calculating unit 143 may calculate the first balancing execution rate (e.g., 1 %) by multiplying a value, obtained by dividing the first balancing execution time (e.g., 7.2 hours) of the first period (e.g., 720 hours) by the first period, by 100. The calculating unit 143 may calculate the second balancing execution rate (e.g., 5 %) by multiplying a value, obtained by dividing the second balancing execution time (e.g., 36 hours) of the second period (e.g., 720 hours) by the second period, by 100.

According to an embodiment, the calculating unit 143 may calculate another balancing execution rate based on the balancing execution time of the other battery unit obtained through the obtaining unit 141.

According to an embodiment, the determining unit 145 may determine a reference rate. According to an embodiment, the determining unit 145 may determine the reference rate based on the other balancing execution rate. For example, the determining unit 145 may determine the other balancing execution rate as the reference rate. In another example, the determining unit 145 may determine an average balancing execution rate of a plurality of other balancing execution rates, obtained by the obtaining unit 141 and/or calculated by the calculating unit 143, as the reference rate.

According to an embodiment, the other balancing execution rate may mean the other balancing execution rate corresponding to the other period before the designated period among at least one balancing execution rate of the battery unit 111, 113, or 115 calculated by the calculating unit 143. In this case, the calculating unit 143 may determine the reference rate based on the first balancing execution rate corresponding to the first period before the second period.

According to another embodiment, the other balancing execution rate may mean the other balancing execution rate of the other battery unit, obtained by the obtaining unit 141 or calculated by the calculating unit 143.

According to an embodiment, the diagnosing unit 147 may diagnose abnormality of the battery unit 111, 113, or 115.

According to an embodiment, the diagnosing unit 147 may diagnose abnormality of the battery unit 111, 113, or 115 by comparing the designated balancing execution rate corresponding to the designated period, out of the at least one balancing execution rate of the battery unit 111, 113, or 115 calculated by the calculating unit 143, with the reference rate. Herein, the reference rate may be a rate previously stored in the memory 140 or a rate calculated by the determining unit 145.

According to an embodiment, the diagnosing unit 147 may diagnose, as an abnormal battery unit, the battery unit 111, 113, or 115 having a difference between the designated balancing execution rate and the reference rate being greater than or equal to a designated value. The diagnosing unit 147 may diagnose, as a normal battery unit, the battery unit 111, 113, or 115 having the difference being less than the designated value. Herein, the designated value may be set variously according to specifications of the battery unit 111, 113, or 115.

For example, when the designated value is set to 3 % and the reference rate is determined as the first balancing execution rate (e.g., 1 %) by the determining unit 145, the diagnosing unit 147 may diagnose the battery unit 111, 113, or 115 as an abnormal battery unit because a difference between the second balancing execution rate (e.g., 5 %) and the first balancing execution rate is 4 % greater than or equal to the designated value.

For an abnormal battery unit having internal shortcircuit or failure, an electronic device including the battery unit may autonomously increase a balancing execution rate. The battery diagnosis apparatus 101 may early diagnose whether the battery unit 111, 113, or 115 having an increasing balancing execution rate when compared to a previous period by using the foregoing characteristics is abnormal, thereby reducing a risk of a damage to the electronic device 103.

According to an embodiment, the abnormality processing unit 149 may perform an abnormality processing function based on an abnormality diagnosis result for the battery unit 111, 113, or 115. In an embodiment, the abnormality processing function may include a notification function or a shortcircuit function.

According to an embodiment, the abnormality processing unit 149 may perform the notification function with respect to an abnormality diagnosis result of the battery unit 111, 113, or 115 and/or information related to the battery unit 111, 113, or 115. For example, the information related to the battery unit 111, 113, or 115 may include manufacturing information of the battery unit 111, 113, or 115 and/or position information regarding arrangement of the battery unit 111, 113, or 115. Herein, the position information regarding arrangement of the battery unit 111, 113, or 115 may include information about a position at which the battery unit 111, 113, or 115 is located in the electronic device 103, more specifically, information about a connection relationship between the battery units 111, 113, and 115.

According to an embodiment, the abnormality processing unit 149 may transmit an abnormality diagnosis result of the battery unit 111, 113, or 115 and/or information related to the battery unit 111, 113, or 115 to the user terminal 105 connected through a wired and/or wireless network.

According to an embodiment, the abnormality processing unit 149 may isolate the abnormal battery unit from the electronic device 103 based on the abnormality diagnosis result of the battery unit 111, 113, or 115. Herein, isolation may include electrical and/or mechanical isolation.

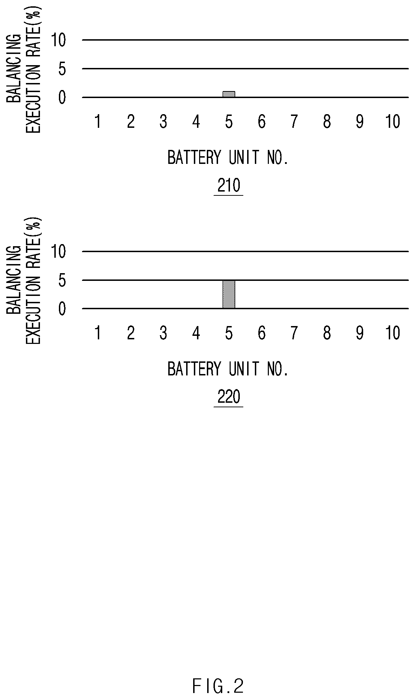

FIG. 2 is a view for describing an example where a balancing execution rate of an abnormal battery unit according to an embodiment increases with a period change. FIG. 2 will be described using components of FIG. 1.

Referring to FIG. 2, a graph 210 showing balancing execution rates calculated based on a time at which a plurality of battery units perform balancing during the first period and a graph 220 showing balancing execution rates calculated based on a time at which balancing is performed during the second period after the first period are shown. Herein, the balancing execution rates may be calculated by the calculating unit 143.

In the graphs 210 and 220, for a fifth battery unit among the plurality of battery units, from the first period to the second period, a balancing execution rate increases from 1% to 5 %. On the other hand, for the other battery units than the fifth battery unit, there is a little change in balancing execution rate in spite of period change.

In this case, the diagnosing unit 147 may diagnose the fifth battery unit as an abnormal battery unit because a difference between the balancing execution rate (1 %) of the first period and the balancing execution rate (5 %) of the second period determined as the reference rate is greater than or equal to a designated value (e.g., 3 %). The diagnosing unit 147 may diagnose the other battery units having no change in balancing execution rate as normal battery units.

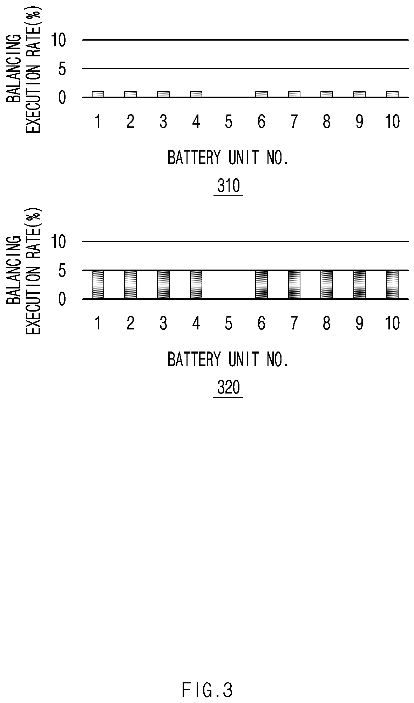

FIG. 3 is a view for describing an example where balancing execution rates of abnormal battery units according to an embodiment increases with a period change. FIG. 3 will be described using components of FIG. 1.

Referring to FIG. 3, a graph 310 showing balancing execution rates calculated based on a time at which a plurality of battery units perform balancing during the first period and a graph 320 showing balancing execution rates calculated based on a time at which balancing is performed during the second period after the first period are shown. Herein, the balancing execution rates may be calculated by the calculating unit 143.

In the graphs 310 and 320, for first to fourth battery units among the plurality of battery units, from the first period to the second period, a balancing execution rate increases from 1 % to 5 %. On the other hand, for the fifth battery unit, there is a little change in balancing execution rate in spite of period change.

In this case, the diagnosing unit 147 may diagnose the first to fourth battery units and sixth to tenth battery units as abnormal battery units because a difference between the balancing execution rate (1 %) of the first period and the balancing execution rate (5 %) of the second period determined as the reference rate is greater than or equal to a designated value (e.g., 3 %). The diagnosing unit 147 may also diagnose the fifth battery unit having no change in balancing execution rate as normal battery units.

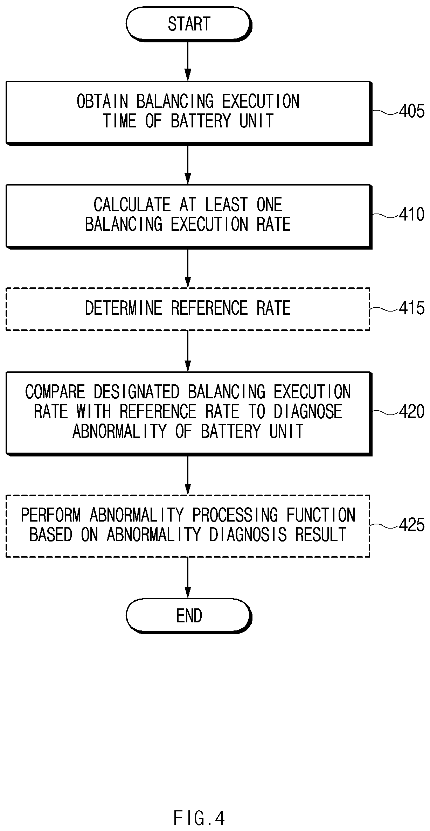

FIG. 4 is an operating flowchart of a battery diagnosis apparatus according to an embodiment. FIG. 4 will be described using components of FIG. 1.

The embodiment shown in FIG. 4 may be an example, and an order of operations according to various embodiments of the present disclosure may be different from that shown in FIG. 4, and some operations shown in FIG. 4 may be omitted, the order of the operations may be changed, or the operations may be merged. For example, in FIG. 4, operation 415 and/or operation 425 may be omitted.

Referring to FIG. 4, in operation 405, the battery diagnosis apparatus 101 may obtain the balancing execution time of the battery unit 111, 113, or 115. According to an embodiment, the battery diagnosis apparatus 101 may obtain the balancing execution time of the battery unit 111, 113, or 115 from the electronic device 103 connected through a wired and/or wireless network. Herein, the balancing execution time may mean a time at which balancing is uniformly executed on states of charge (SOC) having a deviation among the battery units 111, 113, and 115. Such balancing may be performed autonomously inside the electronic device 103. The balancing execution time may mean a time at which the battery unit 111, 113, or 115 executes balancing from a first point in time to a second point in time.

According to an embodiment, the battery diagnosis apparatus 101 may obtain a balancing execution time and/or a balancing execution rate of another battery unit of the same model as the battery unit 111, 113, or 115. According to an embodiment, the battery diagnosis apparatus 101 may obtain the balancing execution time and/or balancing execution rate of the other battery unit from the external device 105 (e.g., an external server) connected through a wired and/or wireless network. Herein, the other battery unit may be of the same model as the battery unit 111, 113, or 115 and may mean a battery unit arranged in an electronic device other than the electronic device 103.

In operation 410, the battery diagnosis apparatus 101 may calculate at least one balancing execution time.

According to an embodiment, the battery diagnosis apparatus 101 may calculate at least one balancing execution rate based on the balancing execution time of the battery unit 111, 113, or 115 obtained in operation 405. For example, the battery diagnosis apparatus 101 may calculate the balancing execution rate for each of a plurality of periods included in a period from the first point in time to the second point in time of the battery unit 111, 113, or 115.

According to an embodiment, the battery diagnosis apparatus 101 may calculate a designated balancing execution rate based on a balancing execution time of a designated period in the obtained balancing execution time, and the designated period. In an embodiment, the battery diagnosis apparatus 101 may calculate the designated balancing execution rate based on a value obtained by dividing the balancing execution time of the designated period by the designated period.

According to an embodiment, the battery diagnosis apparatus 101 may calculate another balancing execution rate based on another balancing execution time of another period before the designated period in the obtained balancing execution time, and the other period. In an embodiment, the battery diagnosis apparatus 101 may calculate the other balancing execution rate based on a value obtained by dividing the other balancing execution time of the other period by the other period. Herein, the other period may have a duration that is the same as or different from the designated period.

According to an embodiment, the battery diagnosis apparatus 101 may calculate another balancing execution rate based on the balancing execution time of the other battery unit obtained in operation 405.

In operation 415, the battery diagnosis apparatus 101 may determine a reference rate. According to an embodiment, the battery diagnosis apparatus 101 may determine the reference rate based on the other balancing execution rate. For example, the battery diagnosis apparatus 101 may determine the other balancing execution rate as the reference rate. In another example, the battery diagnosis apparatus 101 may determine an average balancing execution rate of a plurality of other balancing execution rates, obtained in operation 405 and/or calculated in operation 410, as the reference rate.

According to an embodiment, the other balancing execution rate may mean the other balancing execution rate corresponding to the other period before the designated period among the at least one balancing execution rate of the battery unit 111, 113, or 115 calculated in operation 410.

According to another embodiment, the other balancing execution rate may mean the other balancing execution rate of the other battery unit, obtained in operation 405 or calculated in operation 410.

In operation 420, the battery diagnosis apparatus 101 may diagnose abnormality of the battery unit 111, 113, or 115 by comparing the designated balancing execution rate of the at least one balancing execution rate calculated in operation 410 with the reference rate. Herein, the reference rate may be a rate previously stored in the battery diagnosis apparatus 101 or a rate calculated in operation 415.

According to an embodiment, the battery diagnosis apparatus 101 may diagnose, as an abnormal battery unit, the battery unit 111, 113, or 115 having a difference between the designated balancing execution rate and the reference rate being greater than or equal to a designated value. The battery diagnosis apparatus 101 may diagnose, as a normal battery unit, the battery unit 111, 113, or 115 having the difference being less than the designated value. Herein, the designated value may be set variously according to specifications of the battery unit 111, 113, or 115.

For an abnormal battery unit having internal shortcircuit or failure, an electronic device including the battery unit may autonomously increase a balancing execution rate. The battery diagnosis apparatus 101 may early diagnose whether the battery unit 111, 113, or 115 having an increasing balancing execution rate when compared to a previous period by using the foregoing characteristics is abnormal, thereby reducing a risk of a damage to the electronic device 103.

In operation 425, the battery diagnosis apparatus 101 may perform an abnormality processing function based on an abnormality diagnosis result for the battery unit 111, 113, or 115. In an embodiment, the abnormality processing function may include a notification function or a shortcircuit function.

According to an embodiment, the battery diagnosis apparatus 101 may perform the notification function with respect to an abnormality diagnosis result of the battery unit 111, 113, or 115 and/or information related to the battery unit 111, 113, or 115. For example, the information related to the battery unit 111, 113, or 115 may include manufacturing information of the battery unit 111, 113, or 115 and/or position information regarding arrangement of the battery unit 111, 113, or 115. Herein, the position information regarding arrangement of the battery unit 111, 113, or 115 may include information about a position at which the battery unit 111, 113, or 115 is located in the electronic device 103, more specifically, information about a connection relationship between the battery units 111, 113, and 115.

According to an embodiment, the battery diagnosis apparatus 101 may transmit an abnormality diagnosis result of the battery unit 111, 113, or 115 and/or information related to the battery unit 111, 113, or 115 to the user terminal 105 connected through a wired and/or wireless network.

According to an embodiment, the battery diagnosis apparatus 101 may isolate the abnormal battery unit from the electronic device 103 based on the abnormality diagnosis result of the battery unit 111, 113, or 115. Herein, isolation may include electrical and/or mechanical isolation.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery diagnosis apparatus comprising:
an obtaining unit configured to obtain a balancing execution time of a battery unit;
a calculating unit configured to calculate at least one balancing execution rate based on the balancing execution time; and
a diagnosing unit configured to diagnose abnormality of the battery unit by comparing a designated balancing execution rate corresponding to a designated period with a reference rate.

2. The battery diagnosis apparatus of claim 1, wherein the calculating unit is further configured to calculate the designated balancing execution rate based on a value obtained by dividing the balancing execution time of the battery unit during the designated period by the designated period.

3. The battery diagnosis apparatus of claim 1, further comprising a determining unit configured to determine the reference rate based on another balancing execution rate corresponding to another period before the designated period.

4. The battery diagnosis apparatus of claim 1, further comprising a determining unit configured to determine the reference rate based on another balancing execution rate of another battery unit of the same model as the battery unit.

5. The battery diagnosis apparatus of claim 1, wherein the diagnosing unit is further configured to diagnose the battery unit as an abnormal battery unit when a difference between the designated balancing execution rate and the reference rate is greater than or equal to a designated value.

6. The battery diagnosis apparatus of claim 1, further comprising an abnormality processing unit configured to perform an abnormality processing function based on an abnormality diagnosis result of the battery unit,
wherein the abnormality processing function comprises a notification function and/or a shortcircuit function.

7. The battery diagnosis apparatus of claim 6, wherein the abnormality processing unit is further configured to perform the notification function with respect to the abnormality diagnosis result and/or information related to the battery unit, and
the information related to the battery unit comprises manufacturing information of the battery unit and/or position information regarding arrangement of the battery unit.

8. The battery diagnosis apparatus of claim 1, wherein the battery unit is a battery cell, a battery module, a battery pack, or a battery rack.

9. A battery diagnosis method comprising:
obtaining a balancing execution time of a battery unit;
calculating at least one balancing execution rate based on the balancing execution time; and
diagnosing abnormality of the battery unit by comparing a designated balancing execution rate corresponding to a designated period with a reference rate.

10. The battery diagnosis method of claim 9, wherein the calculating of the at least one balancing execution rate comprises calculating the designated balancing execution rate based on a value obtained by dividing the balancing execution time of the battery unit during the designated period by the designated period.

11. The battery diagnosis method of claim 9, further comprising determining the reference rate based on another balancing execution rate corresponding to another period before the designated period.

12. The battery diagnosis method of claim 9, further comprising determining the reference rate based on another balancing execution rate of another battery unit of the same model as the battery unit.

13. The battery diagnosis method of claim 9, wherein the diagnosing of abnormality of the battery unit comprises diagnosing the battery unit as an abnormal battery unit when a difference between the designated balancing execution rate and the reference rate is greater than or equal to a designated value.

14. The battery diagnosis method of claim 9, further comprising performing an abnormality processing function based on an abnormality diagnosis result of the battery unit,
wherein the abnormality processing function comprises a notification function or a shortcircuit function.

15. The battery diagnosis method of claim 14, wherein the performing of the abnormality processing function comprises performing the notification function with respect to the abnormality diagnosis result and/or information related to the battery unit, and
the information related to the battery unit comprises manufacturing information of the battery unit and/or position information regarding arrangement of the battery unit.
